# EUROPEAN PATENT APPLICATION

(11) **EP 4 779 816 A1**
(43) Date of publication of application: **22.07.2026**
(21) Application number: 23951982.0
(22) Date of filing: 20.10.2023
(51) Int. Cl.: H01R 13/66, H01R 25/16

(54) **ELECTRICAL DEVICE AND TEMPERATURE MEASUREMENT ASSEMBLY**

(30) Priority: 11.09.2023 CN 202322463711 U
(71) Applicant: Sungrow Power Supply Co., Ltd., Hefei, Anhui 230088 (CN)
(72) Inventor: LIU, Long, Hefei, Anhui 230088 (CN); BIE, Wei, Hefei, Anhui 230088 (CN)
(74) Representative: Epping - Hermann - Fischer
(86) International application number: PCT/CN2023/125536
(87) International publication number: WO 2025/055056

(57) **Abstract**

The present application pertains to the field of power electronics, and discloses an electrical device and a temperature measurement assembly. The electrical device comprises a cabinet, a wiring terminal apparatus, a temperature measurement apparatus, an electronic device, and a controller. The wiring terminal apparatus is arranged on the cabinet, the temperature measurement apparatus is arranged on the wiring terminal apparatus, the electronic device is arranged in the cabinet, and the controller is electrically connected to the temperature measurement apparatus and the wiring terminal apparatus. According to the present application, by arranging the temperature measurement apparatus on the wiring terminal apparatus, electrically connecting the temperature measurement apparatus to the controller, and electrically connecting the controller to the electronic device, the controller can, on the basis of a temperature measurement feedback value of the temperature measurement apparatus, carry out actions of fault early warning and device shutdown protection, which can greatly improve the operational reliability of the electrical device, and avoid the problems of overheating and failure at the location of electrical connection caused by a non-standard on-field wiring operation.

## Description

The present application claims the priority of the Chinese Patent Application No. 202322463711.X, titled "ELECTRICAL DEVICE AND TEMPERATURE MEASUREMENT ASSEMBLY", filed on September 11, 2023 with the China National Intellectual Property Administration, which is incorporated herein by reference in its entirety.

### FIELD

The present application relates to the technical field of power electronics, and in particular, to an electrical apparatus and a temperature detection assembly.

### BACKGROUND

At present, for electrical apparatuses with high-current input or output, such as inverters or energy storage current transformers, the conventional wiring solution is as follows: a circular terminal or a copper terminal is crimped to a cable, and then is secured to a copper busbar by a screw. Since the cable required for high-current connection is thick and the selected specification of the circular terminal has a high current-carrying capacity, a terminal securing nut or screw requires a high torque value. During the actual on-site installation, non-standard operations may lead to some issues, such as inadequate tightening of nuts or screws, poor contact of circular terminals, and the like, which results in a sharp increase of thermal resistance at a wiring position. After the apparatus has been running for a period of time, there may be some issues, such as terminal burnout, equipment failure or fire, which brings significant safety hazards and affects the operation stability of electrical apparatus.

### SUMMARY

An object of the present application is to address at least one of the technical issues in the related arts. In view of this, an electrical apparatus and a temperature detection assembly are provided according to the present application, which can greatly improve the operational reliability of the electrical apparatus and avoid overheating failure at electrical connection positions caused by improper on-site wiring operations.

In a first aspect, an electrical apparatus is provided according to the present application, which includes: a cabinet, a terminal block device, a temperature detection device, an electronic component, and a controller. The terminal block device is arranged at the cabinet. The temperature detection device is arranged at the terminal block device. The electronic component is arranged in the cabinet. The controller is electrically connected to the terminal block device and the temperature detection device.

According to the electrical apparatus provided by the present application, the temperature detection device is arranged on the terminal block device, the temperature detection device is electrically connected to the controller, and the controller is electrically connected to the terminal block device, so that the controller can perform a fault alarm and an equipment shutdown protection action based on a temperature detection feedback value of the temperature detection device, which can greatly improve the operational reliability of the electrical apparatus and avoid overheating failure at electrical connection positions caused by non-standard on-site wiring operations.

According to an embodiment of the present application, the cabinet includes a main cabinet body and a junction box, the controller is arranged at the main cabinet body, and the terminal block device is mounted to the junction box; the temperature detection device includes a temperature detector and a transmission line, the temperature detector is arranged at the junction box, one end of the transmission line is connected to the temperature detector, and the other end of the transmission line extends through the junction box and the main cabinet body and is electrically connected to the controller.

According to an embodiment of the present application, the main cabinet body and the junction box are provided with reserved holes, and the other end of the transmission line passes through the junction box and the reserved holes and is electrically connected to the controller.

According to an embodiment of the present application, the terminal block device includes a terminal base and a conductive copper busbar, the terminal base is mounted to the junction box, and the conductive copper busbar is mounted on a side of the terminal base facing away from the main cabinet body; the conductive copper busbar is provided with a first mounting counterbore, and the temperature detector is mounted in the first mounting counterbore.

According to an embodiment of the present application, the terminal block device includes a terminal base and a conductive copper busbar, the terminal base is mounted to the junction box, and the conductive copper busbar is mounted on a side of the terminal base facing away from the main cabinet body; the temperature detection device further includes a conductor base, and the temperature detector is arranged on the conductor base; and the conductor base is mounted to the conductive copper busbar.

According to an embodiment of the present application, the terminal block device includes a terminal base and a conductive copper busbar, the terminal base is mounted to the junction box, and the conductive copper busbar is mounted on a side of the terminal base facing away from the main cabinet body; and the temperature detector is mounted on a surface of the conductive copper busbar.

According to an embodiment of the present application, the terminal block device includes a terminal base, a conductive copper busbar, and a fastener, the terminal base is mounted to the junction box, the conductive copper busbar is mounted on a side of the terminal base facing away from the main cabinet body, and the fastener is mounted on a side of the conductive copper busbar facing away from the terminal base; the temperature detection device further includes a conductor base, and the temperature detector is arranged on the conductor base; and the conductor base is mounted to the fastener.

According to an embodiment of the present application, the terminal block device is provided with a via hole in communication with the reserved hole, and the other end of the transmission line passes through the via hole and the reserved hole and is electrically connected to the controller.

According to an embodiment of the present application, the main cabinet body and the junction box are provided with through holes that correspond to each other and are configured for electrical connection between the terminal block device and the controller; the terminal block device is provided with a via hole in communication with the through holes; the other end of the transmission line passes through the via hole and the through holes and is electrically connected to the controller.

According to an embodiment of the present application, the terminal block device includes a terminal base which is mounted to the junction box; the terminal base is provided with the via hole and a second mounting counterbore, the temperature detector is mounted in the second mounting counterbore, and the other end of the transmission line passes through the via hole and is electrically connected to the controller.

According to an embodiment of the present application, the terminal block device includes a terminal base and a conductive copper busbar, the terminal base is mounted to the junction box, and the conductive copper busbar is mounted on a side of the terminal base facing away from the main cabinet body; the terminal base is provided with the via hole; the conductive copper busbar is provided with a third mounting counterbore, the temperature detector is mounted in the third mounting counterbore, and the other end of the transmission line passes through the via hole and is electrically connected to the controller.

According to an embodiment of the present application, the terminal block device includes a terminal base which is mounted to the junction box; the temperature detection device further includes a conductor base which is mounted to the terminal base; the temperature detector is arranged on the conductor base, and the other end of the transmission line passes through the via hole and is electrically connected to the controller.

According to an embodiment of the present application, the terminal block device includes a terminal base which is mounted to the junction box; the temperature detector is mounted on a surface of the terminal base, and the other end of the transmission line passes through the via hole and is electrically connected to the controller.

According to an embodiment of the present application, at least part of the terminal block device passes through the through holes; or at least part of the controller passes through the through holes; or a connecting wire between the terminal block device and the controller passes through the through holes.

According to an embodiment of the present application, an accommodation space is defined by the cabinet, and the terminal block device, the temperature detection device, the electronic component, and the controller are mounted in the accommodation space.

According to an embodiment of the present application, the terminal block device includes a terminal base and a conductive copper busbar, the conductive copper busbar is mounted on the terminal base and is provided with a fourth mounting counterbore; the temperature detection device includes a temperature detector and a transmission line; the temperature detector is mounted in the fourth mounting counterbore, and the other end of the transmission line is electrically connected to the controller.

According to an embodiment of the present application, the terminal block device includes a terminal base and a conductive copper busbar mounted on the terminal base; the temperature detection device includes a temperature detector, a transmission line, and a conductor base; the temperature detector is arranged at the conductor base, the conductor base is mounted on the conductive copper busbar, and the other end of the transmission line is electrically connected to the controller.

According to an embodiment of the present application, the terminal block device includes a terminal base and a conductive copper busbar mounted on the terminal base; the temperature detection device includes a temperature detector and a transmission line, the temperature detector is mounted on a surface of the conductive copper busbar, and the other end of the transmission line is electrically connected to the controller.

According to an embodiment of the present application, the terminal block device includes a terminal base, a conductive copper busbar, and a fastener, the conductive copper busbar is mounted on the terminal base, and the fastener is mounted on a side of the conductive copper busbar facing away from the terminal base; the temperature detection device includes a temperature detector, a transmission line, and a conductor base; the temperature detector is arranged on the conductor base, the conductor base is mounted to the fastener, and the other end of the transmission line is electrically connected to the controller.

According to an embodiment of the present application, the terminal block device includes a terminal base which is provided with a fifth mounting counterbore; the temperature detection device includes a temperature detector and a transmission line; the temperature detector is mounted in the fifth mounting counterbore, and the other end of the transmission line is electrically connected to the controller.

According to an embodiment of the present application, the terminal block device includes a terminal base; the temperature detection device includes a temperature detector, a transmission line, and a conductor base; the temperature detector is arranged on the conductor base, the conductor base is mounted to the terminal base, and the other end of the transmission line is electrically connected to the controller.

According to an embodiment of the present application, the terminal block device includes a terminal base; the temperature detection device includes a temperature detector and a transmission line; the temperature detector is mounted on a surface of the terminal base, and the other end of the transmission line is electrically connected to the controller.

According to an embodiment of the present application, the terminal block device is arranged outside the cabinet, and the cabinet is provided with a wiring hole; the temperature detection device includes a temperature detector and a transmission line, the temperature detector is arranged at the terminal block device, one end of the transmission line is connected to the temperature detection device, and the other end of the transmission line passes through the wiring hole and is electrically connected to the controller.

In a second aspect, a temperature detection assembly is provided according to the present application, which is applied to an electrical apparatus. The electrical apparatus includes a cabinet, an electronic component, and a controller. The electronic component is arranged in the cabinet, and the controller is electrically connected to a terminal block device. The temperature detection assembly includes: a terminal block device configured to be arranged at the cabinet and be electrically connected to the controller, and a temperature detection device configured to be arranged at the terminal block device and be electrically connected to the controller.

The additional aspects and advantages of the present application are partially presented in the following description, some of which will be apparent from the following description, or be understood by practice of the present application.

### BRIEF DESCRIPTION OF THE DRAWINGS

The above and/or additional aspects and advantages of the present application become apparent and easily understood from the description of the embodiments in conjunction with the following drawings.
FIG. 1 is a schematic structural view of an electrical apparatus according to an embodiment of the present application;
FIG. 2 is another schematic structural view of an electrical apparatus according to an embodiment of the present application;
FIG. 3 is a schematic structural view of a cabinet according to an embodiment of the present application;
FIG. 4 is a schematic structural view of a temperature detection device according to an embodiment of the present application;
FIG. 5 is another schematic structural view of a temperature detection device according to an embodiment of the present application;
FIG. 6 is a schematic partial view of an electrical apparatus according to an embodiment of the present application;
FIG. 7 is a schematic structural view of a terminal block device according to an embodiment of the present application;
FIG. 8 is a schematic structural view of a terminal block device and a temperature detection device according to an embodiment of the present application; and
FIG. 9 is a partial section view of an electrical apparatus according to an embodiment of the present application.

Reference signs in the figures are listed as follows:
1 cabinet, 11 main cabinet body, 12 junction box, 13 reserved hole, 14 through hole;
2 terminal block device, 21 terminal base, 211 via hole, 212 second mounting counterbore, 22 conductive copper busbar, 221 first mounting counterbore, 222 third mounting counterbore, 23 fastener;
3 temperature detection device, 31 temperature detector, 32 transmission line, 33 conductor base;
4 controller.

### DETAILED DESCRIPTION OF THE EMBODIMENTS

The embodiments of the present application are described in detail below, and several examples of the embodiments are shown in the accompanying drawings. The same or similar reference signs throughout represent for the same or similar elements or elements with the same or similar functions. The embodiments described below with reference to the accompanying drawings are exemplary and are only used to explain the present application, and should not be construed as limitations of the present application.

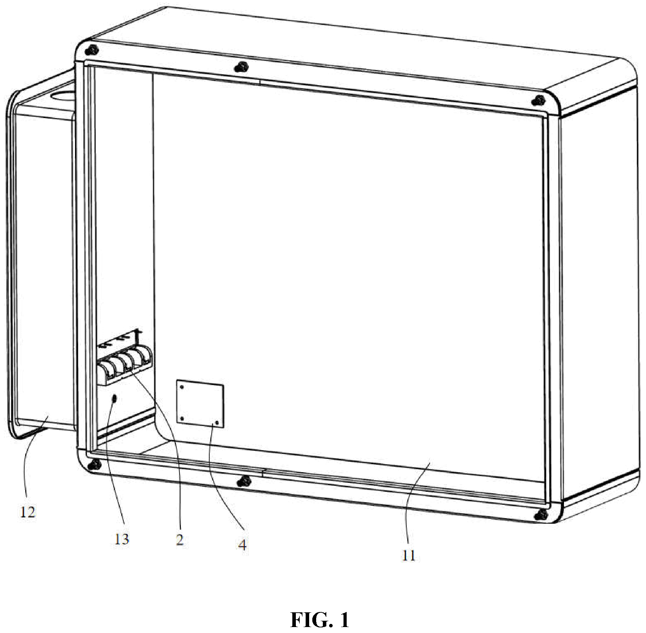

An electrical apparatus and a temperature detection assembly according to embodiments of the present application are described below with reference to FIG. 1 to FIG. 9.

The electrical apparatus may be a device that requires high current input or output, such as a Power Conversion System (PCS), an inverter, a ring main unit, or a control cabinet.

The electrical apparatus includes: a cabinet 1, a terminal block device 2, a temperature detection device 3, an electronic component and a controller 4.

The cabinet 1 may be a plastic or metal cabinet, or may be a compartment constructed by reinforced concrete.

As shown in FIG. 1, the terminal block device 2, the temperature detection device 3, and the electronic component are all arranged at the cabinet 1.

The terminal block device 2 is arranged at the cabinet 1 and is configured for electrically connecting a cable and the controller 4, and the cable is connected and secured to the terminal block device 2 by a screw.

The temperature detection device 3 is arranged at the terminal block device 2. The temperature detection device 3 is configured for detecting a temperature of the terminal block device 2 and sending a temperature detection feedback value to the controller 4.

The electronic component is arranged inside the cabinet 1, which may be a reactor, a fan, etc.

The controller 4 is electrically connected to the temperature detection device 3 and the terminal block device 2. The controller 4 controls the temperature detection device 3 to collect data. The controller 4 can receive the temperature detection feedback value detected by the temperature detection device 3. In a case that the temperature detection feedback value is higher than a preset value, the controller 4 can perform a fault alarm and equipment shutdown protection.

In the related arts, when an electrical apparatus is required for high-current input or output, OT (Open terminal) or DT (Deutsch terminal) compression cables are typically used, and these cables are secured to a terminal copper busbar by screws. During field installation, non-standard practices may lead to some issues, such as loose nuts/screws or poor OT contact, which results in a sharp increase of thermal resistance at connections and easily causes some issues, such as terminal burnout, equipment failure or fire. These pose significant safety hazards and affect the operation stability of the electrical apparatus.

According to the electrical apparatus provided in embodiments of the present application, the temperature detection device 3 is arranged on the terminal block device 2, the temperature detection device 3 is electrically connected to the controller 4, and the controller 4 is electrically connected to the terminal block device 2. The controller 4 can perform a fault alarm and an equipment shutdown protection action for the apparatus based on the temperature detection feedback value of the temperature detection device 3, which can greatly improve the operational reliability of the electrical apparatus and avoid overheating failure at the electrical connection positions caused by improper on-site wiring operations.

The controller 4 and the terminal block device 2 may be installed in at least the following three manners.

In a first manner, the controller 4 and the terminal block device 2 are both mounted in the cabinet and in the same space.

In this embodiment, the cabinet 1 defines an accommodation space. The terminal block device 2, the temperature detection device 3, the electronic component, and the controller 4 are mounted in the accommodation space. The controller 4 is directly electrically connected to the temperature detection device 3, requiring no through-holes, which facilitates the installation.

The terminal block device 2 is arranged inside the cabinet 1, which can protect the terminal block device 2.

In a second manner, the controller 4 and the terminal block device 2 are mounted in different spaces.

In this embodiment, the terminal block device 2 is arranged outside the cabinet 1, and the cabinet 1 is provided with a wiring hole. The terminal block device 2 may be provided with a protective structure. The terminal block device 2 is arranged on an outer wall of the cabinet 1, which facilitates the maintenance.

The temperature detection device 3 includes a temperature detector and a transmission line. The temperature detector 31 is arranged on the terminal block device 2. One end of the transmission line 32 is connected to the temperature detection device 3 and the other end of the transmission line 32 passes through the wiring hole and is electrically connected to the controller 4.

In a third manner, the controller 4 and the terminal block device 2 are both mounted in the cabinet and mounted in different spaces.

In this embodiment, as shown in FIG. 1, the cabinet 1 includes a main cabinet body 11 and a junction box 12. The controller 4 is arranged in the main cabinet body 11, and the terminal block device 2 is mounted in the junction box 12.

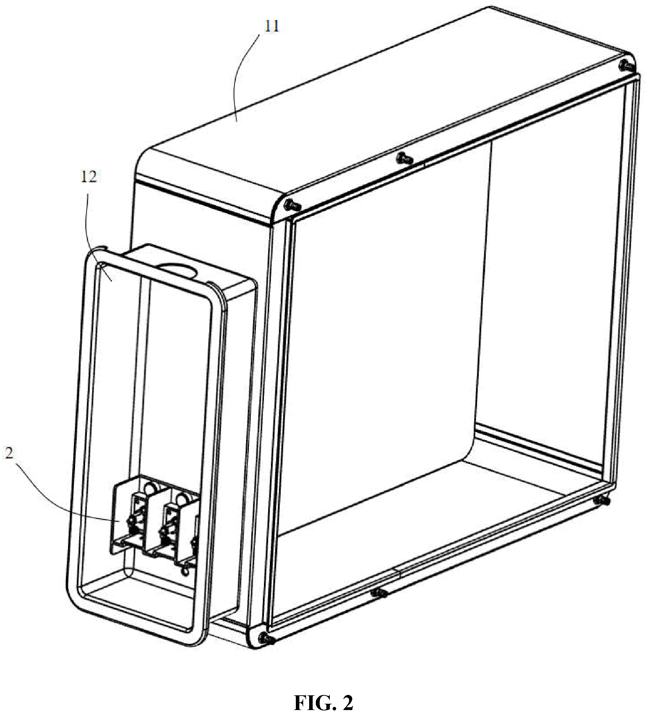

As shown in FIG. 2, the junction box 12 is mounted on the main cabinet body 11, and the junction box 12 may be connected to a side wall of the main cabinet body 11 by a threaded connector, welding, snap-fit connection, etc.

The terminal block device 2 is mounted in the junction box 12, and the terminal block device 2 may be connected to a side wall of the junction box 12 by a threaded connector, snap-fit connection, etc.

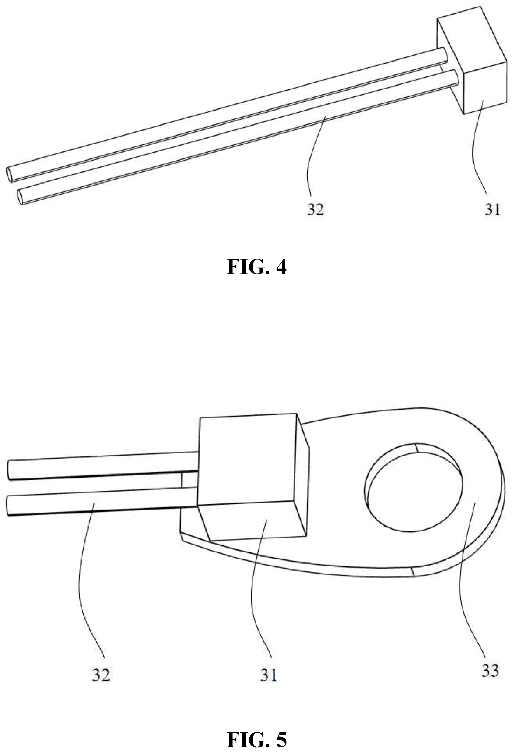

As shown in FIG. 4, the temperature detection device 3 includes a temperature detector 31 and a transmission line 32. The temperature detector 31 is arranged in the junction box 12. One end of the transmission line 32 is connected to the temperature detector 31, and the other end of the transmission line 32 passes through the junction box 12 and the main cabinet body 11 and is electrically connected to the controller 4.

It can be understood that, the controller 4 and the terminal block device 2 are mounted in different spaces, and the temperature detection device 3 is mounted on the terminal block device 2. That is, the controller 4 and the temperature detection device 3 are mounted in different spaces. The transmission line 32, which electrically connects the controller 4 and the temperature detection device 3 passes through the side walls of both the main cabinet body 11 and the junction box 12.

The transmission line 32 may be a rigid conductor (e.g., copper), or a flexible wire, or may include a front section which is connected to the temperature detector 31 and is a hard conductor and a rear section which is a flexible cable and transitioned to the hard conductor.

The temperature detector 31 is arranged on the terminal block device 2, that is, a temperature detection point is located at the terminal block device 2. The temperature detector 31 is configured for detecting the temperature of the terminal block device 2.

In this embodiment, the transmission line 32 is configured for passing through the junction box 12 and the main cabinet body 11 to electrically connect the temperature detector 31 and the controller 4.

The transmission line 32, which passes through the junction box 12 and the main cabinet body 11, may be configured in at least the following two structural arrangements.

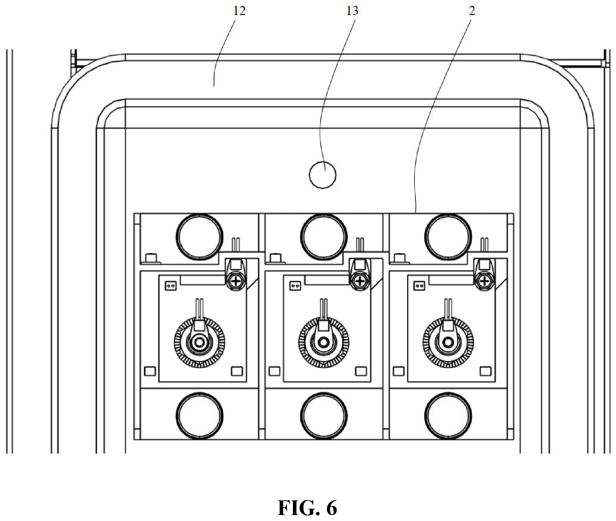

In a first structural arrangement, as shown in FIG. 6, the main cabinet body 11 and the junction box 12 are each provided with reserved holes 13, and the other end of the transmission line 32 passes through the junction box 12 and the reserved holes 13 to be electrically connected to the controller 4.

In the structural arrangement, the main cabinet body 11 is in communication with the junction box 12 through the reserved hole 13, the temperature detector 31 is arranged in the junction box 12, and the transmission line 32 passes through the junction box 12 and the reserved holes 13 and is electrically connected to the controller 4.

In some embodiments, the reserved hole 13 is located at a side wall of the junction box 12 that is not blocked by the terminal block device 2, which facilitates the transmission line 32 passing through the reserved hole 13.

In some embodiments, the terminal block device 2 is provided with a via hole 211 for communication with the reserved hole 13, and the other end of the transmission line 32 passes through the via hole 211 and the reserved hole 13 and is electrically connected to the controller 4.

In the embodiment, the temperature detector 31 is mounted on the terminal block device 2, and the transmission line 32 extends towards the via hole 211.

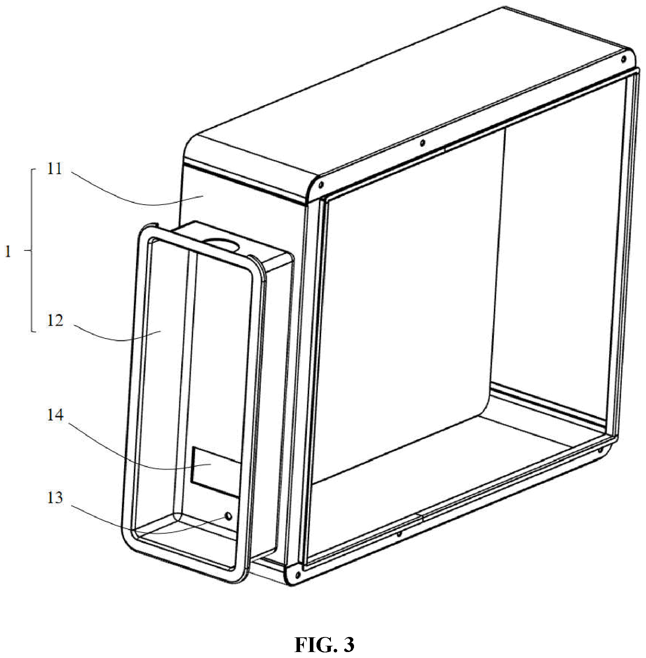

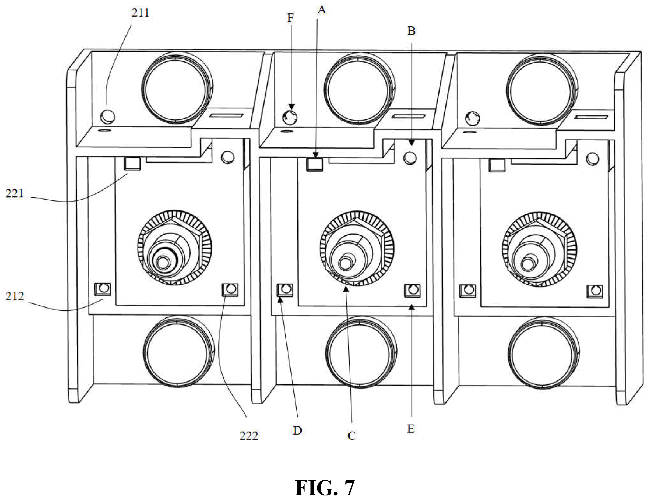

In a second structural arrangement, as shown in FIG. 3, the main cabinet body 11 and the junction box 12 are provided with through holes 14 which are aligned. The through holes 14 are configured for electrically connecting the terminal block device 2 and the controller 4. As shown in FIG. 7, the terminal block device 2 is provided with a via hole 211 for communication with the through hole 14. The transmission line 32 passes through the via hole 211 and the through hole 14 and is electrically connected to the controller 4.

The transmission line 32 may be a flexible wire and may extend in any direction.

In some embodiments, the other end of the transmission line 32 extends in a direction towards the main cabinet body to facilitate passing through the holes and reduce the length of the transmission line 32, facilitating installation and maintenance.

The mounting position of the terminal block device 2 is configured in at least the following three arrangements.

In a first arrangement, as shown in FIG. 1, at least part of the terminal block device 2 passes through the through hole 14.

In this embodiment, a part of the terminal block device 2 is located in the junction box 12, and another part of the terminal block device 2 passes through the through hole 14 and is located in the main cabinet body 11.

The via hole 211 extends through the terminal block device 2, that is, the main cabinet body 11 is in communication with the junction box 12 through the via hole 211.

With the via hole 211, an electrical connection between the transmission line 32 and the controller 4 can be achieved without providing the reserved holes 13 at the main cabinet body 11 and the junction box 12, and thus the operation is easy and the use is flexible.

Sealing between the transmission line 32 and the via hole 211 may be achieved by pouring sealant or by a soft rubber plug.

The via hole 211 may be located at any portion of the terminal block device 2, which may be determined based on the mounting location of the temperature detector 31, as long as the locking electrical connection between the terminal block device 2 and the OT terminal is not affected.

In a second arrangement, at least part of the controller 4 passes through the through hole 14, that is, the part of the controller 4 and the terminal block device 2 are located in the same space. The controller 4 may be directly electrically connected to the terminal block device 2 and the temperature detector 31 without the need for wire threading, which facilitates the installation.

In a third arrangement, a connecting wire between the terminal block device 2 and the controller 4 passes through the through hole 14.

The controller 4 and the terminal block device 2 are located in different spaces. The connecting wire between the terminal block device 2 and the controller 4 passes through the through hole 14 to electrically connect the terminal block device 2 and the controller 4. The mounting location is clear, which facilities the maintenance.

The other end of the transmission line 32 may pass through the through hole 14 to be electrically connected to the controller 4, or the other end of the transmission line 32 may pass through the via hole 211 and the through hole 14 and is electrically connected to the controller 4.

In a case that the controller 4 is arranged in the main cabinet body 11 and the terminal block device 2 is mounted at the junction box 12, the main cabinet body 11 and the junction box 12 are provided with the reserved hole 13, and the other end of the transmission line 32 passes through the junction box 12 and the reserved holes 13 and is electrically connected to the controller 4.

In this embodiment, the temperature detector 31 is mounted on the terminal block device 2 and has at least the following four mounting locations.

Firstly, the terminal block device 2 includes a terminal base 21 and a conductive copper busbar 22. The terminal base 21 is mounted at the junction box 12, and the conductive copper busbar 22 is mounted on a side of the terminal base 21 facing away from the main cabinet body.

The terminal base 21 and a side wall of the junction box 12 may be connected by a threaded connector, snap-fit connection, etc.

The conductive copper busbar 22 may be connected by adhesive, a threaded connector, etc.

The conductive copper busbar 22 is provided with a first mounting counterbore 221, and the temperature detector 31 is mounted in the first mounting counterbore 221 to collect the temperature of the conductive copper busbar 22 for transmission control, as shown at location A in FIG. 7.

It can be understood that, the transmission line 32 is a flexible wire. The transmission line 32 may extend outward to a side away from the main cabinet body, bypass an insulation barrier, and then extend in a direction towards the reserved hole 13. Alternatively, the transmission line 32 may pass through the insulation barrier and then extend in the direction towards the reserved hole 13.

The other end of the transmission line 32 may extend towards the reserved hole 13 to shorten the length of the transmission line 32, which facilitates installation and maintenance and reduces costs.

The first mounting counterbore 221 may be located at any location of the conductive copper busbar 22, as long as the locking electrical connection between the conductive copper busbar 22 and the terminal is not affected.

The first mounting counterbore 221 may be located on a side of the conductive copper busbar 22 close to the reserved hole 13 to shorten the transmission distance of the transmission line 32, which improves the data accuracy and facilitates wire threading.

The first mounting counterbore 221 may be located at the conductive copper busbar 22 near a wiring point, so that the temperature detection point is close to the wiring point, which improves the temperature detection accuracy.

Secondly, the terminal block device 2 includes a terminal base 21 and a conductive copper busbar 22. The terminal base 21 is mounted in the junction box 12, and the conductive copper busbar 22 is mounted on a side of the terminal base 21 facing away from the main cabinet body.

As shown in FIG. 5, the temperature detection device 3 further includes a conductor base 33, and the temperature detector 31 is arranged on the conductor base 33.

The temperature detector 31 may be connected to the conductor base 33 by a screw, adhesive, welding, etc.

The temperature detector 31 is insulated from the conductor base 33.

The conductor base 33 is mounted on the conductive copper busbar 22 so as to achieve the transmission control by collecting the temperature of the conductive copper busbar 22, as shown at location B in FIG. 7.

The other end of the transmission line 32 may extend towards the reserved hole 13 to shorten the length of the transmission line 32, which facilities installation and maintenance.

The conductor base 33 may be provided with a through hole, and may be connected to the conductive copper busbar 22 by a screw.

The terminal base 21 is provided with an insulation barrier protruding outwards, and the insulation barrier is provided with a through hole. The other end of the transmission line 32 may pass through the through hole of the insulation barrier and extend towards the reserved hole 13.

Thirdly, the terminal block device 2 includes a terminal base 21, a conductive copper busbar 22, and a fastener 23. The terminal base 21 is mounted in the junction box 12, the conductive copper busbar 22 is mounted on a side of the terminal base 21 facing away from the main cabinet body, and the fastener 23 is mounted on a side of the conductive copper busbar 22 facing away from the terminal base 21.

The fastener 23 is configured for connecting a cable.

As shown in FIG. 5, the temperature detection device 3 further includes a conductor base 33. The temperature detector 31 is arranged on the conductor base 33. The conductor base 33 is mounted to the fastener 23, as shown at location C in FIG. 7.

The fastener 23 is thermally conductive, and the temperature of the fastener 23 is collected for transmission control.

The temperature detector 31 may be secured to a screw provided on a top of the fastener 23. The screw conducts heat, enabling the detection of the temperature of the terminal connector.

The conductor base 33 may be provided with a through hole, and the fastener 23 passes through the through hole to be connected to the conductive copper busbar 22.

The conductor base 33 is mounted on the fastener 23, so that the temperature monitoring point is located at the wiring point, which improves the detection accuracy of the temperature detector 31.

The other end of the transmission line 32 may extend towards the reserved hole 13 to shorten the length of the transmission line 32, which facilitates installation and maintenance.

Fourthly, the terminal block device 2 includes a terminal base 21 and a conductive copper busbar 22. The terminal base 21 is mounted in the junction box 12, and the conductive copper busbar 22 is mounted on a side of the terminal base 21 facing away from the main cabinet body. The temperature detector 31 is mounted on a surface of the conductive copper busbar 22.

The terminal base 21 and a side wall of the junction box 12 may be connected by a threaded connector, snap-fit connection, etc.

The conductive copper busbar 22 may be connected to the terminal base 21 by adhesive, a threaded connector, etc.

The temperature detector 31 may be connected to the surface of the conductive copper busbar 22 by welding, adhesive, etc.

The terminal base 21 is provided with an insulation barrier protruding outwards, and the insulation barrier is provided with a through hole. The other end of the transmission line 32 may extend through the through hole of the insulation barrier and extend towards the reserved hole 13.

In a case that the controller 4 is arranged in the main cabinet body 11 and the terminal block device 2 is mounted in the junction box 12, the terminal block device 2 is provided with a via hole 211 in communication with the through hole 14. The other end of the transmission line 32 passes through the through hole 14 and the via hole 211 and is electrically connected to the controller 4.

In this embodiment, the temperature detector 31 is mounted on the terminal block device 2 and has at least the following four mounting locations.

Firstly, the terminal block device 2 includes a terminal base 21 which is mounted at the junction box 12. The terminal base 21 is provided with a via hole 211 and a second mounting counterbore 212. The temperature detector 31 is mounted in the second mounting counterbore 212. The other end of the transmission line 32 passes through the via hole 211 to be electrically connected to the controller 4, the temperature of the terminal base 21 is collected to achieve the transmission control, as shown at location D in FIG. 7.

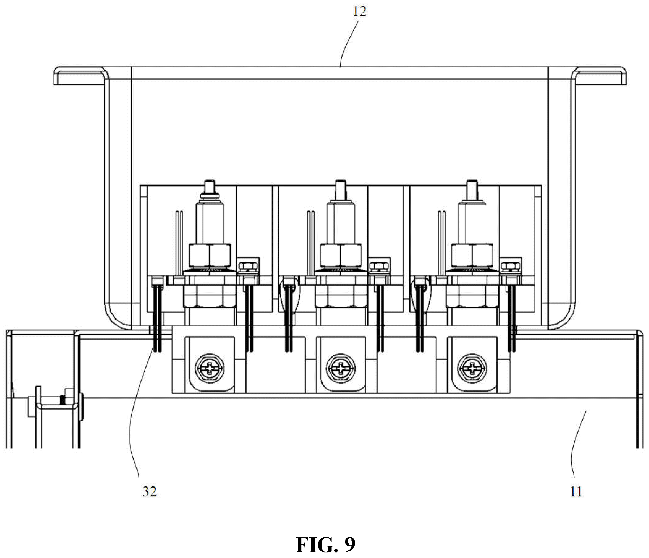

The via hole 211 extends through the terminal base 21, and the second mounting counterbore 212 corresponds to the via hole 211. When the temperature detector 31 is mounted in the second mounting counterbore 212, the transmission line 32 extends towards the main cabinet body 11 and can pass through the via hole 211 to be electrically connected to the controller 4, as shown in FIG. 9.

It should be noted that, the temperature detector 31 is arranged close to the conductive copper busbar 22, either on a side portion of the conductive copper busbar 22 or below the conductive copper busbar 22. The transmission line 32 may pass through the terminal base 21, or be exposed on an outer side of the terminal base 21. In the case that the transmission line 32 is exposed on the outer side of the terminal base 21, the transmission line 32 should be kept clear of an electrical-connection area of the OT terminal.

Secondly, the terminal block device 2 includes a terminal base 21 and a conductive copper busbar 22. The terminal base 21 is mounted at the junction box 12, and the conductive copper busbar 22 is mounted on a side of the terminal base 21 facing away from the main cabinet body. The terminal base 21 is provided with a via hole 211. The conductive copper busbar 22 is provided with a third mounting counterbore 222, and the temperature detector 31 is mounted in the third mounting counterbore 222. The other end of the transmission line 32 passes through the via hole 211 to be electrically connected to the controller 4, and the temperature of the conductive copper busbar 22 is collected to achieve the transmission control, as shown at location E in FIG. 7.

The third mounting counterbore 222 corresponds to the via hole 211. When the temperature detector 31 is mounted in the third mounting counterbore 222, the transmission line 32 extends towards the main cabinet body 11, and can pass through the via hole 211 to be electrically connected to the controller 4, as shown in FIG. 9.

The temperature detector 31 is mounted to the conductive copper busbar 22, so that the temperature detection point is close to the wiring point, enabling accurate temperature measurement.

Thirdly, as shown in FIG. 5, the terminal block device 2 includes a terminal base 21, which is mounted at the junction box 12. The temperature detection device 3 further includes a conductor base 33 which is mounted on the terminal base 21. The temperature detector 31 is arranged on the conductor base 33. The other end of the transmission line 32 passes through the via hole 211and is electrically connected to the controller 4.

The terminal base 21 is provided with an insulation barrier protruding outwards, and the conductor base 33 is mounted on the insulation barrier of the terminal base 21. The transmission line 32 extends towards the main cabinet body 11 and can pass through the via hole 211 to be electrically connected to the controller 4, and the temperature of the terminal base 21 is collected to achieve the transmission control, as shown at location F in FIG. 7.

The conductor base 33 may be mounted on the terminal base 21 by a screw, adhesive, welding, etc.

Fourthly, the terminal block device 2 includes a terminal base 21 which is mounted in the junction box 12.

The temperature detector 31 is mounted on a surface of the terminal base 21, and the other end of the transmission line 32 passes through the via hole 211 and is electrically connected to the controller 4.

The temperature detector 31 may be connected to the surface of the terminal base 21 by welding, adhesive, etc., so that the installation is simple.

In some embodiments, the temperature detector 31 and the terminal base 21 may be formed by injection molding, and the transmission line 32 is directly encapsulated in the terminal base 21.

In some embodiments, an adhesive may be potted between the temperature detector 31 and the first mounting counterbore 221, between the temperature detector 31 and the second mounting counterbore 212, or between the temperature detector 31 and the third mounting counterbore 222. The adhesive may be an insulating adhesive to achieve fixation and insulation.

In another embodiment, the body of the temperature detector 31 is subjected to an insulating treatment, and then the temperature detector 31 is tightly fitted into the first mounting counterbore 221 or the third mounting counterbore 222 for fixation.

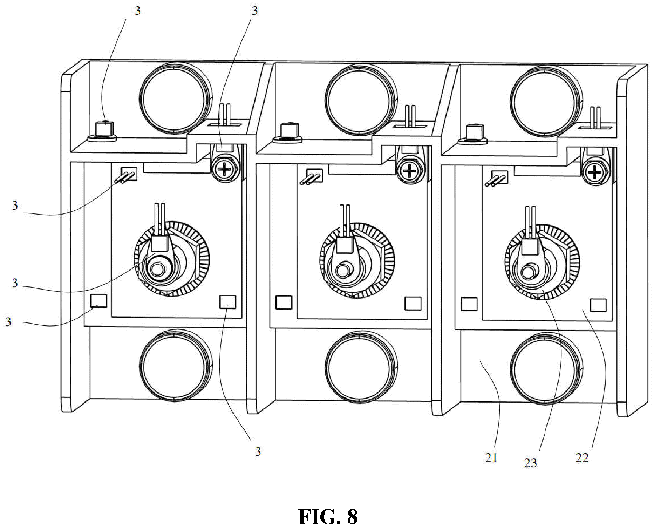

It should be noted that, FIG. 8 is a schematic view showing that the temperature detection devices 3 are mounted at all six locations A to F of the terminal block device 2 in FIG. 7. In actual use, the temperature detection device 3 may be selectively mounted at one or two locations of the terminal block device 2, so as to monitor the temperature of the terminal block device 2. For example, any one of the six locations A to F in FIG. 7 may be selected for mounting the temperature detection device 3, and the corresponding through hole is provided based on the selected mounting location to allow the transmission line 32 to pass through.

In a case that the accommodation space is defined by the cabinet 1, and the terminal block device 2, the temperature detection device 3, the electronic component, and the controller 4 are all mounted in the accommodation space, the terminal block device 2 and the temperature detection device 3 are mounted in at least the following seven manners.

In a first manner, the terminal block device 2 includes a terminal base 21 and a conductive copper busbar 22. The conductive copper busbar 22 is mounted on the terminal base 21 and is provided with a fourth mounting counterbore. The temperature detection device 3 includes a temperature detector 31 and a transmission line 32. The temperature detector 31 is mounted in the fourth mounting counterbore, and the other end of the transmission line 32 is electrically connected to the controller 4.

In this manner, the temperature detector 31 is mounted in the fourth mounting counterbore to achieve the transmission control by collecting the temperature of the conductive copper busbar 22.

The fourth mounting counterbore may be located at any location of the conductive copper busbar 22, as long as the locking electrical connection between the conductive copper busbar 22 and the terminal is not affected.

In a second manner, the terminal block device 2 includes a terminal base 21 and a conductive copper busbar 22 mounted on the terminal base 21. The temperature detection device 3 includes a temperature detector 31, a transmission line 32, and a conductor base 33. The temperature detector 31 is arranged on the conductor base 33, and the conductor base 33 is mounted on the conductive copper busbar 22. The other end of the transmission line 32 is electrically connected to the controller 4.

In this manner, the temperature detector 31 may be connected to the conductor base 33 by a screw, bonding, welding, etc.

The temperature detector 31 is insulated from the conductor base 33. The conductor base 33 may be provided with a through hole. The conductor base 33 may be connected to the conductive copper busbar 22 by a screw.

In a third manner, the terminal block device 2 includes a terminal base 21 and a conductive copper busbar 22 mounted on the terminal base 21. The temperature detection device 3 includes a temperature detector 31 and a transmission line 32. The temperature detector 31 is mounted on a surface of the conductive copper busbar 22. The other end of the transmission line 32 is electrically connected to the controller 4.

In this manner, the temperature detector 31 may be connected to the surface of the conductive copper busbar 22 by welding, gluing, etc.

In a fourth manner, the terminal block device 2 includes a terminal base 21, a conductive copper busbar 22, and a fastener 23. The conductive copper busbar 22 is mounted on the terminal base 21, and the fastener 23 is mounted on a side of the conductive copper busbar 22 facing away from the terminal base 21. The temperature detection device 3 includes a temperature detector 31, a transmission line 32, and a conductor base 33. The temperature detector 31 is arranged on the conductor base 33, and the conductor base 33 is mounted to the fastener 23. The other end of the transmission line 32 is electrically connected to the controller 4.

In this manner, the fastener 23 can conduct heat, and the transmission control is achieved by collecting the temperature of the fastener 23.

The temperature detector 31 may be fastened to a small screw provided at a top of the fastener 23. The screw conducts heat, allowing for the detection of the temperature of a terminal connector.

The conductor base 33 is mounted to the fastener 23, so that the temperature monitoring point is located at the wiring point, which improves the detection accuracy of the temperature detector 31.

In a fifth manner, the terminal block device 2 includes a terminal base 21 which is provided with a fifth mounting counterbore. The temperature detection device 3 includes a temperature detector 31 and a transmission line 32. The temperature detector 31 is mounted in the fifth mounting counterbore. The other end of the transmission line 32 is electrically connected to the controller 4.

In this manner, the temperature detector 31 is mounted in the fifth mounting counterbore so as to achieve the transmission control by collecting the temperature of the terminal base 21.

In a sixth manner, the terminal block device 2 includes a terminal base 21. The temperature detection device 3 includes a temperature detector 31, a transmission line 32, and a conductor base 33. The temperature detector 31 is arranged on the conductor base 33, and the conductor base 33 is mounted on the terminal base 21. The other end of the transmission line 32 is electrically connected to the controller 4.

In this manner, the temperature detector 31 may be connected to the conductor base 33 by a screw, bonding, welding, etc.

The temperature detector 31 is insulated from the conductor base 33. The conductor base 33 may be provided with a through hole. The conductor base 33 may be connected to the terminal base 21 by a screw.

In a seventh manner, the terminal block device 2 includes a terminal base 21. The temperature detection device 3 includes a temperature detector 31 and a transmission line 32. The temperature detector 31 is mounted on a surface of the terminal base 21, and the other end of the transmission line 32 is electrically connected to the controller 4.

In this manner, the temperature detector 31 may be connected to the surface of the terminal base 21 by adhesive, etc.

According to the electrical apparatus provided by the embodiments of the present application, the temperature detection device 3 is arranged on the terminal block device 2, the temperature detection device 3 is electrically connected to the controller 4, and the controller 4 is electrically connected to the terminal block device 2, so that the controller 4 can perform a fault warning and an equipment shutdown protection action based on the temperature detection feedback value of the temperature detection device 3, which can greatly improve the operational reliability of the electrical apparatus and avoid overheating failure at the electrical connection positions caused by non-standard on-site wiring operations. The temperature detector 31 is designed to be located in the electrical connection area for installation operations, so as to maximize proximity to potential failure points, which improves the temperature-detection sensitivity. By designing multiple mounting positions for the temperature detector 31 on the terminal block device 2, the range of application scenarios is increased. Sealing between the temperature detector 31 and the terminal block device 2 improves both the temperature detection accuracy of the temperature detector 31 and the sealing protection reliability of the terminal block device 2.

A temperature detection assembly is further provided according to the present application, which is applied to an electrical apparatus. The electrical apparatus includes a cabinet 1, an electronic component, and a controller 4. The electronic component is arranged in the cabinet 1, and the controller 4 is electrically connected to the electronic component.

The temperature detection assembly includes a terminal block device 2 and a temperature detection device 3. In an embodiment, the terminal block device 2 is configured to be arranged at the cabinet 1, and is configured to be electrically connected to the controller 4. The temperature detection device 3 is configured to be arranged at the terminal block device 2, and is configured to be electrically connected to the controller 4.

According to the temperature detection assembly provided by the embodiments of the present application, the temperature detection assembly is arranged at the electrical apparatus, the temperature detection device 3 is arranged at the terminal block device 2 and is electrically connected to the controller 4, and the controller 4 is electrically connected to the terminal block device 2, so that the controller 4 can perform the fault warning and the equipment shutdown protection action based on the temperature detection feedback value of the temperature detection device 3, which can greatly improve the operational reliability of the electrical apparatus and avoid overheating failure at the electrical connection positions caused by non-standard on-site wiring operations. The temperature detector 31 is designed to be located in the electrical connection area for installation operations to maximize proximity to potential failure points, which improves the temperature-detection sensitivity. By designing multiple mounting positions for the temperature detector 31 on the terminal block device 2, the range of application scenarios is increased. Sealing between the temperature detector 31 and the terminal block device 2 improves both the temperature-detection accuracy of the temperature detector 31 and the sealing protection reliability of the terminal block device 2.

The terms "first", "second", etc., in the specification and the claims of the present application are used to distinguish similar objects and not to describe a specific order or sequence. It should be understood that such terms may be interchangeable in appropriate circumstances, so that the embodiments of the present application can be implemented in an order other than those illustrated or described herein. The objects distinguished by "first", "second", etc., are generally of the same class and are not limited in number, for example, the number of first object may be one or more. In addition, the term "and/or" in the specification and the claims indicates at least one of the connected objects, and the character "/" generally indicates an "or" relationship between the preceding and following related objects.

In the description of the present application, it should be understood that, the terms "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumstantial", etc., indicate the orientations or positional relationships based on the orientations or positional relationships shown in the accompanying drawings, and are only for the convenience of describing the present application and simplifying the description, and do not indicate or imply that a device or element referred to must have a specific orientation, or be constructed and operated in a specific orientation, and therefore should not be construed as limiting the present application.

In the description of the present application, "a first feature" and "a second feature" may include one or more of the features.

In the description of the present application, "multiple" means two or more.

In the description of the present application, a first feature being "above" or "below" a second feature may include a direct contact between the first and second features, or an indirect contact between the first and second features via another feature between them.

In the description of the present application, a first feature being "on", "above", and "over" a second feature includes scenarios where the first feature is directly above or obliquely above the second feature, or merely indicates that the first feature is at a higher horizontal level than the second feature.

In the description of the specification, descriptions of the reference terms "an embodiment", "some embodiments", "illustrative embodiment", "example", "specific example", or "some examples" mean that a specific feature, structure, material, or characteristic described in connection with such embodiment or example is included in at least one embodiment or example of the present application. In the specification, the illustrative expressions of the above terms do not necessarily refer to the same embodiment or example. Moreover, the specific feature, structure, material, or characteristic described may be combined in any one or more embodiments or examples in a suitable manner.

Although the embodiments of the present application have been shown and described, it can be understood for those skilled in the art that various changes, modifications, substitutions, and alterations can be made to these embodiments without departing from the principles and purposes of the present application. The scope of the present application is limited by the claims and their equivalents.

## Claims

1. An electrical apparatus, **characterized by** comprising:
a cabinet;
a terminal block device provided at the cabinet;
a temperature detection device provided at the terminal block device;
an electronic component provided in the cabinet; and
a controller electrically connected to the terminal block device and the temperature detection device.

2. The electrical apparatus according to claim 1, wherein
the cabinet comprises a main cabinet body and a junction box, the controller is arranged at the main cabinet body, and the terminal block device is mounted to the junction box; and
the temperature detection device comprises a temperature detector and a transmission line, the temperature detector is arranged at the junction box, one end of the transmission line is connected to the temperature detector, and the other end of the transmission line extends through the junction box and the main cabinet body and is electrically connected to the controller.

3. The electrical apparatus according to claim 2, wherein
the main cabinet body and the junction box are provided with reserved holes, and the other end of the transmission line passes through the junction box and the reserved holes and is electrically connected to the controller.

4. The electrical apparatus according to claim 3, wherein
the terminal block device comprises a terminal base and a conductive copper busbar, the terminal base is mounted to the junction box, and the conductive copper busbar is mounted on a side of the terminal base facing away from the main cabinet body; and
the conductive copper busbar is provided with a first mounting counterbore, and the temperature detector is mounted in the first mounting counterbore.

5. The electrical apparatus according to claim 3, wherein
the terminal block device comprises a terminal base and a conductive copper busbar, the terminal base is mounted to the junction box, and the conductive copper busbar is mounted on a side of the terminal base facing away from the main cabinet body;
the temperature detection device further comprises a conductor base, and the temperature detector is arranged on the conductor base; and
the conductor base is mounted to the conductive copper busbar.

6. The electrical apparatus according to claim 3, wherein
the terminal block device comprises a terminal base and a conductive copper busbar, the terminal base is mounted to the junction box, and the conductive copper busbar is mounted on a side of the terminal base facing away from the main cabinet body; and
the temperature detector is mounted on a surface of the conductive copper busbar.

7. The electrical apparatus according to claim 3, wherein
the terminal block device comprises a terminal base, a conductive copper busbar, and a fastener, the terminal base is mounted to the junction box, the conductive copper busbar is mounted on a side of the terminal base facing away from the main cabinet body, and the fastener is mounted on a side of the conductive copper busbar facing away from the terminal base;
the temperature detection device further comprises a conductor base, and the temperature detector is arranged on the conductor base; and
the conductor base is mounted to the fastener.

8. The electrical apparatus according to claim 3, wherein
the terminal block device is provided with a via hole in communication with the reserved holes, and the other end of the transmission line passes through the via hole and the reserved holes and is electrically connected to the controller.

9. The electrical apparatus according to claim 2, wherein
the main cabinet body and the junction box are provided with through holes that correspond to each other and are configured for electrical connection between the terminal block device and the controller;
the terminal block device is provided with a via hole in communication with the through holes; and
the other end of the transmission line passes through the via hole and the through holes and is electrically connected to the controller.

10. The electrical apparatus according to claim 9, wherein
the terminal block device comprises a terminal base mounted to the junction box; and
the terminal base is provided with the via hole and a second mounting counterbore, the temperature detector is mounted in the second mounting counterbore, and the other end of the transmission line passes through the via hole and is electrically connected to the controller.

11. The electrical apparatus according to claim 9, wherein
the terminal block device comprises a terminal base and a conductive copper busbar, the terminal base is mounted to the junction box, and the conductive copper busbar is mounted on a side of the terminal base facing away from the main cabinet body;
the terminal base is provided with the via hole; and
the conductive copper busbar is provided with a third mounting counterbore, the temperature detector is mounted in the third mounting counterbore, and the other end of the transmission line passes through the via hole and is electrically connected to the controller.

12. The electrical apparatus according to claim 9, wherein
the terminal block device comprises a terminal base mounted to the junction box;
the temperature detection device further comprises a conductor base mounted to the terminal base; and
the temperature detector is arranged on the conductor base, and the other end of the transmission line passes through the via hole and is electrically connected to the controller.

13. The electrical apparatus according to claim 9, wherein
the terminal block device comprises a terminal base mounted to the junction box; and
the temperature detector is mounted on a surface of the terminal base, and the other end of the transmission line passes through the via hole and is electrically connected to the controller.

14. The electrical apparatus according to claim 9, wherein
at least part of the terminal block device passes through the through holes; or
at least part of the controller passes through the through holes; or
a connecting wire between the terminal block device and the controller passes through the through holes.

15. The electrical apparatus according to claim 1, wherein
an accommodation space is defined by the cabinet, and the terminal block device, the temperature detection device, the electronic component, and the controller are mounted in the accommodation space.

16. The electrical apparatus according to claim 15, wherein
the terminal block device comprises a terminal base and a conductive copper busbar, the conductive copper busbar is mounted on the terminal base and is provided with a fourth mounting counterbore;
the temperature detection device comprises a temperature detector and a transmission line; and
the temperature detector is mounted in the fourth mounting counterbore, and the other end of the transmission line is electrically connected to the controller.

17. The electrical apparatus according to claim 15, wherein
the terminal block device comprises a terminal base and a conductive copper busbar mounted on the terminal base;
the temperature detection device comprises a temperature detector, a transmission line, and a conductor base; and
the temperature detector is arranged at the conductor base, the conductor base is mounted to the conductive copper busbar, and the other end of the transmission line is electrically connected to the controller.

18. The electrical apparatus according to claim 15, wherein
the terminal block device comprises a terminal base and a conductive copper busbar mounted on the terminal base; and the temperature detection device comprises a temperature detector and a transmission line, the temperature detector is mounted on a surface of the conductive copper busbar, and the other end of the transmission line is electrically connected to the controller.

19. The electrical apparatus according to claim 15, wherein
the terminal block device comprises a terminal base, a conductive copper busbar, and a fastener, the conductive copper busbar is mounted on the terminal base, and the fastener is mounted on a side of the conductive copper busbar facing away from the terminal base;
the temperature detection device comprises a temperature detector, a transmission line, and a conductor base; and
the temperature detector is arranged at the conductor base, the conductor base is mounted to the fastener, and the other end of the transmission line is electrically connected to the controller.

20. The electrical apparatus according to claim 15, wherein
the terminal block device comprises a terminal base which is provided with a fifth mounting counterbore;
the temperature detection device comprises a temperature detector and a transmission line; and
the temperature detector is mounted in the fifth mounting counterbore, and the other end of the transmission line is electrically connected to the controller.

21. The electrical apparatus according to claim 15, wherein
the terminal block device comprises a terminal base;
the temperature detection device comprises a temperature detector, a transmission line, and a conductor base; and
the temperature detector is arranged at the conductor base, the conductor base is mounted to the terminal base, and the other end of the transmission line is electrically connected to the controller.

22. The electrical apparatus according to claim 15, wherein
the terminal block device comprises a terminal base;
the temperature detection device comprises a temperature detector and a transmission line; and
the temperature detector is mounted on a surface of the terminal base, and the other end of the transmission line is electrically connected to the controller.

23. The electrical apparatus according to claim 1, wherein
the terminal block device is arranged outside the cabinet, and the cabinet is provided with a wiring hole; and
the temperature detection device comprises a temperature detector and a transmission line, the temperature detector is arranged at the terminal block device, one end of the transmission line is connected to the temperature detector, and the other end of the transmission line passes through the wiring hole and is electrically connected to the controller.

24. A temperature detection assembly, **characterized by** being applied to an electrical apparatus, the electrical apparatus comprising a cabinet, an electronic component, and a controller, wherein the electronic component is arranged in the cabinet, and the controller is electrically connected to the electronic component;
wherein the temperature detection assembly comprises:
a terminal block device configured to be arranged at the cabinet and configured to be electrically connected to the controller; and
a temperature detection device configured to be arranged at the terminal block device and configured to be electrically connected to the controller.
